Europäisches Patentamt

European Patent Office

Office européen des brevets

(11) Publication number: **0 544 356 A2**

## EUROPEAN PATENT APPLICATION

(21) Application number: **92203544.9**

(22) Date of filing: **18.11.92**

(51) Int. Cl.5: **G06F 15/332**

(30) Priority: **26.11.91 EP 91203086**

(43) Date of publication of application:
**02.06.93 Bulletin 93/22**

(84) Designated Contracting States:
**DE FR GB IT**

(71) Applicant: **N.V. Philips' Gloeilampenfabrieken
Groenewoudseweg 1
NL-5621 BA Eindhoven(NL)**

(72) Inventor: **Bruekers, Alphons Antonius Maria
Lambertus
c/o Int. Octrooibureau B.V., Prof Holstlaan 6
NL-5656 AA Eindhoven(NL)**

Inventor: **Van den Enden, Adrianus Wilhelmus
Maria
c/o Int. Octrooibureau B.V., Prof Holstlaan 6
NL-5656 AA Eindhoven(NL)**
Inventor: **Tolhuizen, Ludovicus Marinus
Gerardus Maria
c/o Int. Octrooibureau B.V., Prof Holstlaan 6
NL-5656 AA Eindhoven(NL)**

(74) Representative: **Kooiman, Josephus Johannes
Antonius et al
INTERNATIONAAL OCTROOIBUREAU B.V.
Prof. Holstlaan 6
NL-5656 AA Eindhoven (NL)**

(54) Device for performing a one-dimensional forward transformation, and inverse transformation.

(57) A one-dimensional forward transform and a one-dimensional inverse transform which can be used for, for example, picture transform coding but also for subband coding. The matrix based on this transform is decomposed. This means that it is written as a product of permutation matrices and triangular matrices. A permutation matrix is implemented in a permutation circuit and a triangular matrix is implemented in a triangular circuit so that the forward transform is realised by means of a cascade arrangement of permutation circuits and triangular circuits. The transform thereby realised is perfectly invertible.

FIG.6

EP 0 544 356 A2

A. Background of the invention.

## A(1) Field of the invention.

The invention relates to a device for converting a cluster of N input signals into a cluster of N output signals, the relationship between the two clusters being defined by an N*N matrix.

Such a device may be used, for example, for picture transform coding, in which case the input signals represent pixels of the television picture.

Although the invention emanates from research in the field of picture transform coding, it may also be used for other purposes, for example, for subband coding.

## A(2) Description of the prior art.

Picture transform coding is a method of converting a two-dimensional block of pixels of a television picture into a two-dimensional block of what are called coefficients, or conversely, by means of a two-dimensional linear transform. The first-mentioned case is referred to as forward two-dimensional transform, the last-mentioned case is referred to as inverse two-dimensional transform. The transform matrix A based on this linear transform is preferably chosen to be such that this two-dimensional transform can be realised by successively performing a horizontal and a vertical one-dimensional transform. If W represents an N*N matrix of pixels and Y represents an N*N matrix of coefficients, such a two-dimensional linear transform may be mathematically written as follows:

(1)    $Y = A^T W A$

In this expression $A^T$ represents the transposed matrix of A.

For more information about picture transform coding the interested reader is referred to, for example, References 1 and 2 in section C.

To regain a pixel matrix $\tilde{W}$ from the coefficient matrix Y, this coefficient matrix Y is subjected to an inverse two-dimensional transform. This may be mathematically written as follows:

$$(2)... \qquad \tilde{W} = (A^T)^{-1} Y A^{-1}$$

In this expression $A^{-1}$ represents the inverted version of the matrix A.

The coefficient matrix indicated in expression (1) and the pixel matrix indicated in expression (2) are obtained by performing a number of vector-matrix multiplications. For example, for realising expression (1) the internal product of a row of $A^T$ and a column vector of W is computed first. Subsequently the internal product of each row vector of the product matrix $A^T W$ thus obtained and each column of A is computed. Such a vector-matrix multiplication is referred to as a one-dimensional transform and may in general be mathematically written as follows:

(3)    $P = BX$

In this expression X represents an N-point input vector, B represents the N*N transform matrix and P represents the N-point output vector. To regain the original input vector X from this output vector P, this output vector P must be subjected to an inverse one-dimensional transform based on a transform matrix B', and which can be mathematically written as follows:

$$(4)... \qquad B'P = B'BX = (B'B)X = \tilde{X}$$

The output vector $\tilde{X}$ which is thereby obtained will only be identical to X if the product of the matrices B'B yields the unity matrix. With some exceptions, this will generally be achieved only if these matrices B' and B have an infinite precision. For many matrices this can only be achieved by allowing the elements of such a matrix to have an infinite number of symbols. The number of symbols with which the elements of such a matrix can be represented will of course have to be finite. In practice, the matrix B will therefore be a matrix which is derived from an ideal (theoretical) matrix $\overline{B}$ having an infinite precision by subjecting the matrix elements of $\overline{B}$ to some suitable rounding operation so as to limit the number of symbols per element. In a corresponding manner the matrix elements of B' are obtained by subjecting the matrix elements of the inverted theoretical matrix $\overline{B}^{-1}$ to such an operation. Bach of these matrices B and B' can be optimized in this manner. As a result, the product B'B will generally not be fully identical to the unity matrix so that $\widetilde{X}$ will not be fully identical to X; in other words, the inversion cannot be performed perfectly.

In a great many circumstances this difference between X and $\widetilde{X}$ will appear to be acceptable. However, if $\widetilde{X}$ is once more successively subjected to a one-dimensional forward and inverse transform, the output vector which is then obtained and which will be referred to as $\widetilde{X}'$ will have an unacceptable deviation with respect to X, which deviation further increases with further forward and inverse transforms.

B. Object and summary of the invention.

It is an object of the invention to provide a device for performing a one-dimensional transform which is perfectly invertible.

According to the invention, the one-dimensional transform device comprises a cascade arrangement of a plurality of permutation circuits and a plurality of triangular circuits. Such a permutation circuit has associated therewith an N*N permutation matrix with matrix elements $\tilde{a}_{rk}$ and a triangular circuit has associated therewith an N*N triangular matrix with matrix elements $a'_{rk}$ (r represents the row number and k represents the column number). A permutation matrix has exactly one non-zero matrix element per row and per column. The triangular matrix has on one of the diagonals, elements all of which are equal to one and on only one side of this diagonal matrix elements which are unequal to zero. The mutual sequence of these circuits is determined by the transform matrix itself. Both the permutation circuit and the triangular circuit have N inputs and N outputs. The permutation circuit is adapted to supply an output data word at an output r, which word is equal to a weighted version of its input data words at one predetermined input k, which weighting is based on a weighting function described by the matrix element $\tilde{a}_{rk}$. The triangular circuit is adapted to supply an output data word at each output r, which word is equal to the input data word at one predetermined input (k) which is different for each output, augmented with weighted versions of input data words at other inputs q ≠ k, each weighting being based on a weighting function and the weighting function to which the input data words at input q are subjected in order to contribute to an output data word at output r being exclusively described by the matrix element $a'_{rq}$.

It is to be noted that the weighting functions $\tilde{a}_{rk}$ and $a'_{rk}$ may be scalar quantities (real or complex). This is the case, for example, with picture transform coding. In the previously mentioned case of subband coding these weighting functions may be very complicated functions.

It is also to be noted that the input data words may represent real numbers but also complex numbers, while a series of data words is usually referred to as a time-discrete signal.

The invention is based on the recognition that each invertible N*N matrix whose determinant is a perfect factor can be decomposed. This means that it can be written as a product of a number of N*N permutation matrices and a number of N*N triangular matrices whose associated determinants are also perfect factors. A perfect factor is a number which itself as well as its reciprocal value can be represented with a finite number of symbols in a given numerical system. In the binary system these are, for example the numbers j, -1, $2^i$, with i being a positive or negative integral number including zero and j = $\sqrt{-1}$ and some combinations of these three numbers such as, for example -j/8 and 1+j. The number of times these different matrices occur in this product, as well as their sequence is of course determined by the transform matrix itself, is different from transform matrix to transform matrix and is not unique. The latter means that different decompositions of a given matrix are possible.

It is to be noted that if in a concrete case the determinant of the transform matrix does not appear to be a perfect factor, such a matrix can often be scaled in such a way that its determinant does become a perfect factor. Such a scaling can usually be chosen to be such that it does not influence the mutual relation of the matrix elements in the final result.

It is also to be noted that with such a decomposition permutation matrices may be produced whose determinant is a perfect factor, but whose non-zero matrix elements are not perfect factors. As will be apparent hereinafter, such a matrix is not perfectly invertible. However, this problem can be solved by further decomposing such a permutation matrix.

Once a given transform matrix has been written as the product of permutation and triangular matrices (the matrix is decomposed), the desired forward transform device is obtained by cascading the associated permutation circuits and triangular circuits. An inverse transform device which is perfectly inverting can be derived therefrom in a very simple manner, *viz.* by interchanging the inputs and outputs of this forward transform device, inverting the polarity of the weighting functions of the triangular circuits ($a'_{rk}$ becomes $-a'_{rk}$) and by taking the reciprocal values of the weighting functions of the permutation circuits ($\tilde{a}_{rk}$ becomes $1/\tilde{a}_{rk}$).

All these measures will lead to the envisaged effect, which will be illustrated with reference to the Figures.

C. References.

1. Real-time Orthogonal Transformation of Colour Television Pictures;
H. Bacchi, A. Moreau;
Philips Technical Review, Vol. 38, No. 4/5, 1978/1979, pp. 119-130
2. One-dimensional Linear Picture Transformer;
R. Woudsma et al
European Patent Application no. EP 0 286 184
3. Matrices for Engineers;
A.D. Kraus;
Hemisphere Publishing Corp./Springer Verlag Berlin
pp. 113-127
4. Matrix Theory;
J.N. Franklin;
Prentice-Hall Series in applied Mathematics;
pp. 203-208
5. Multirate Digital Filters, Filter Banks, Polyphase Networks, and
Applications: A Tutorial;
P.P. Vaidyanathan;
Proceedings of the IEEE, Vol. 78, No. 1, January 1990, page 59

D. Brief description of the Figures.

Fig. 1 shows some symbols which are used in the further Figures;
Fig. 2 shows a one-dimensional transform;
Figs. 3, 4 and 5 show some permutation matrices with associated permutation circuits;
Figs. 6, 7, 8 and 9 show some triangular matrices with associated triangular circuits;
Figs. 10 and 11 show examples of transform circuits for concrete transform matrices;
Fig. 12 shows the general principle of a subband coding system;
Fig. 13 shows a band-splitting network and equivalents thereof for use in the subband coding system of Fig. 12;
Fig. 14 shows a reconstruction network and equivalents thereof for use in the subband coding system of Fig. 12;
Fig. 15 shows amplitude characteristics for a high-pass filter and a low-pass filter for subband coding;
Fig. 16 shows an implementation of a subband coding system in accordance with the aspects of the present invention.

E. Explanation of the invention.

# E(1) Introduction.

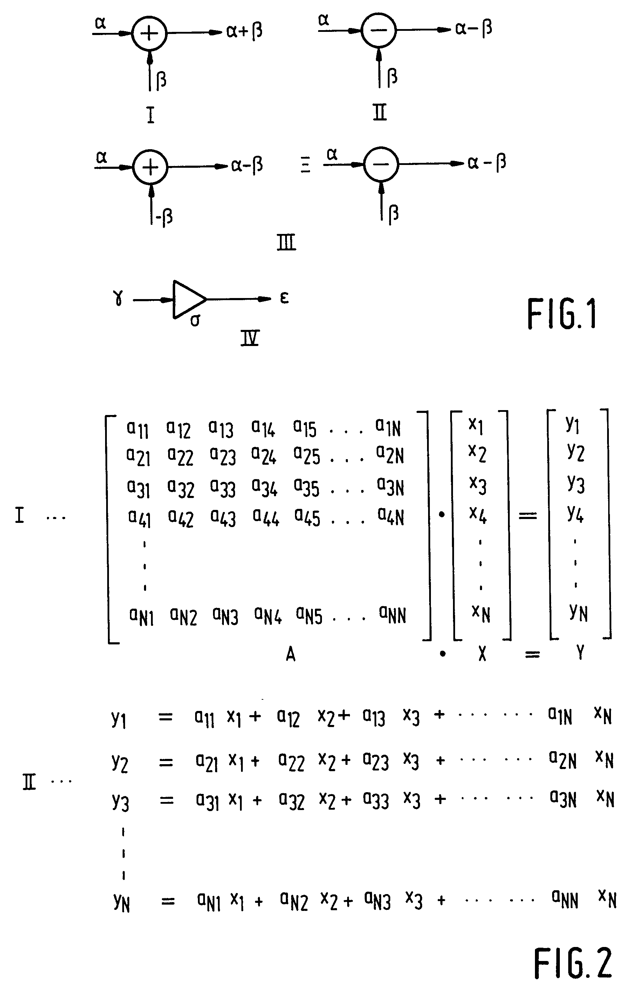

Fig. 1 shows a number of symbols used in the Figures referred to in this explanation of the invention. More particularly, the symbol at I represents an adder circuit which receives the two data words $\alpha$ and $\beta$ and supplies the data word $\alpha + \beta$. The symbol at II represents a subtractor circuit which receives the two data words $\alpha$ and $\beta$ and supplies the difference word $\alpha-\beta$. It will be evident that the adder circuit shown at I can be replaced by the subtractor circuit shown at II, if the data word $-\beta$ instead of the data word $\beta$ is applied to this adder circuit. This identity is shown at III. The symbol at IV represents a weighting network with weighting function $\delta$. In response to the data word or series of data words $\gamma$ applied to this weighting network, this weighting network supplies a weighted version $\epsilon$ of $\gamma$, for example, $\epsilon = \delta\gamma$. It is to be noted

that $\delta$ may be a scalar but also a function of the frequency, or, as is common practice in the description of digital signals, a function of the variable $z$.

## E(2) The one-dimensional forward transform.

Fig. 2 shows at I a one-dimensional transform as the product of an invertible N*N matrix A with matrix elements $a_{rk}$ (here r is the row number and k is the column number r,k = 1, 2, 3, ... N) with an input data vector X comprising the N input data words $x_1$, $x_2$, $x_3$, ..., $X_N$. This product yields an output data vector Y with output data words $y_1$, $y_2$, $y_3$, ..., $y_N$, in which the relation between an output data word and the N input data words is shown at II in Fig. 2.

As already noted, the invention is based on the recognition that each invertible matrix whose determinant is a perfect factor can be written as a product of a number of elementary matrices, to wit permutation matrices $\tilde{A}$ and triangular matrices A' whose respective determinants are also perfect factors.

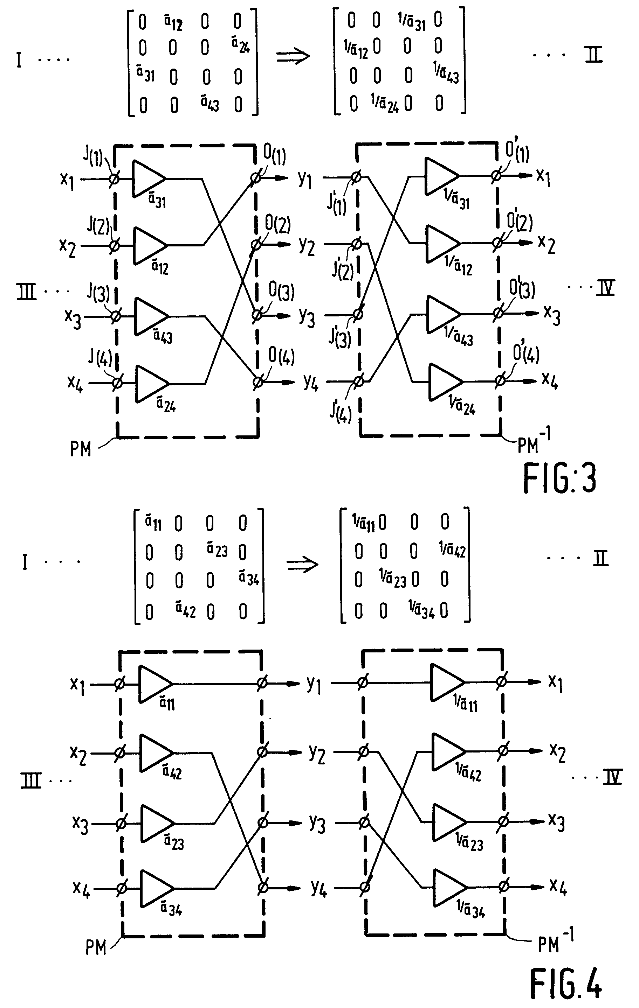

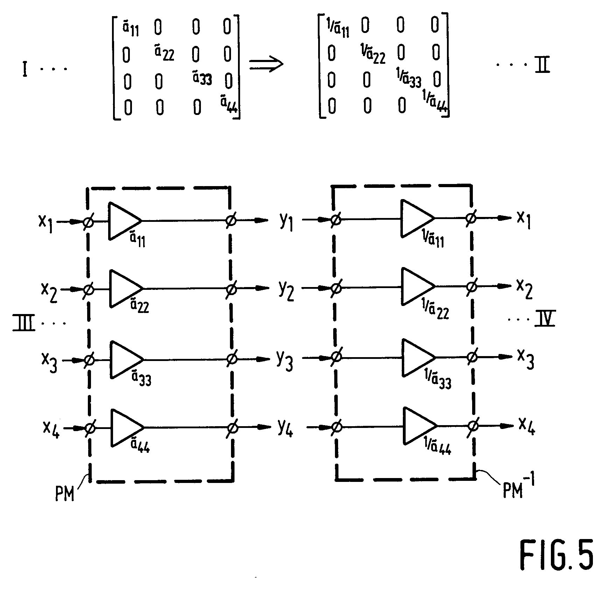

A permutation matrix has per row and per column exactly one matrix element $\tilde{a}_{rk}$ which is unequal to zero, so that there are N! different permutation matrices with N*N matrix elements. Figs. 3, 4 and 5 show three different 4*4 permutation matrices. The matrix shown at I in Fig. 5 is a diagonal matrix.

The permutation circuits PM associated with these permutation matrices directly result from the matrix multiplication in Fig. 2 and these circuits are shown at III in Figs. 3, 4 and 5. These permutation circuits have four inputs J(.) and four outputs O(.). The respective input data words $x_1$, $x_2$, $x_3$ and $x_4$ of the input data vector X are applied to these four inputs and in response thereto the respective output data words $y_1$, $y_2$, $y_3$ and $y_4$ of the output data vector Y occur at the outputs O(.). The respective input data words are subjected in the weighting networks to weighting operations as are defined by the non-zero matrix elements of the permutation matrix. The outputs of these weighting networks are connected to the outputs O(.) in different ways, dependent on the permutation matrix to be implemented.

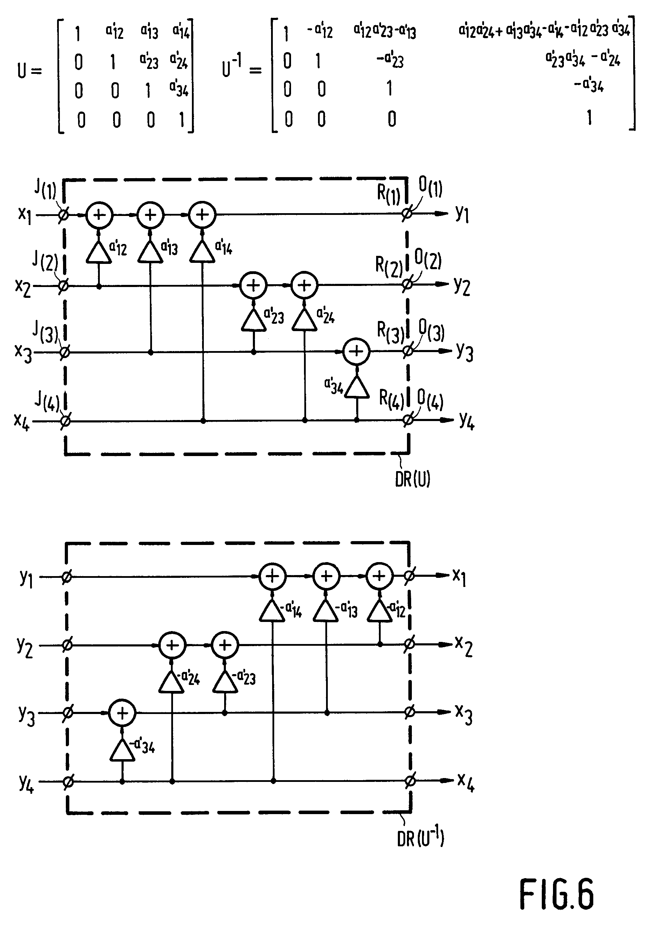

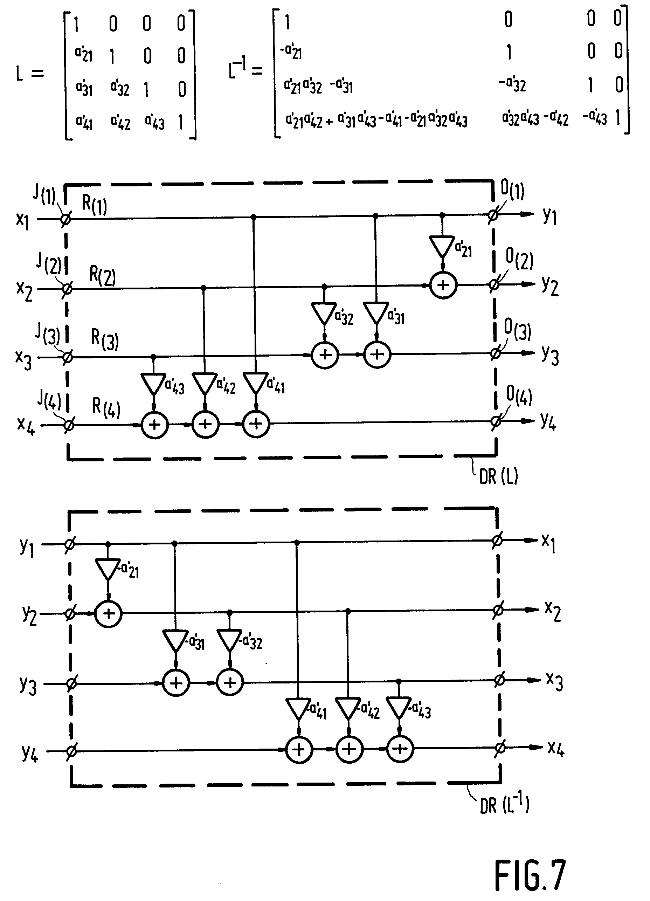

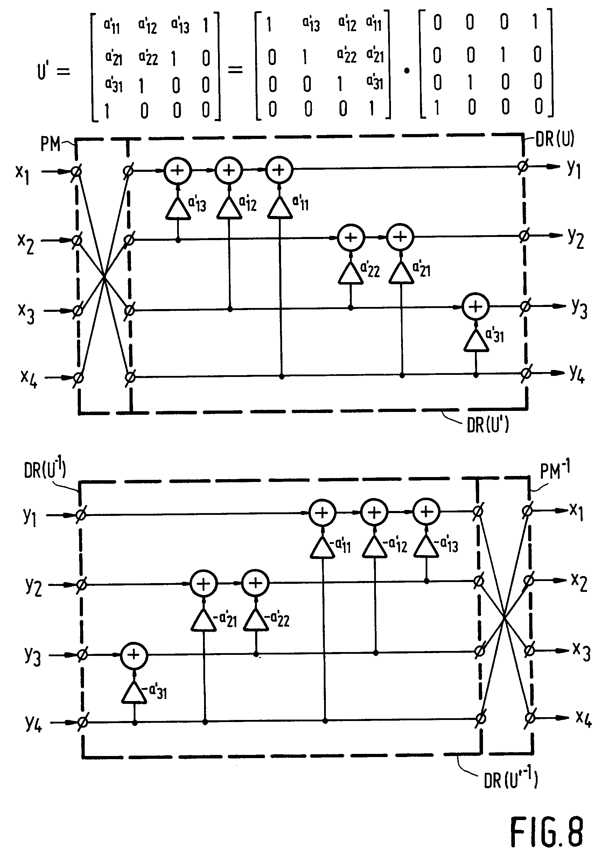

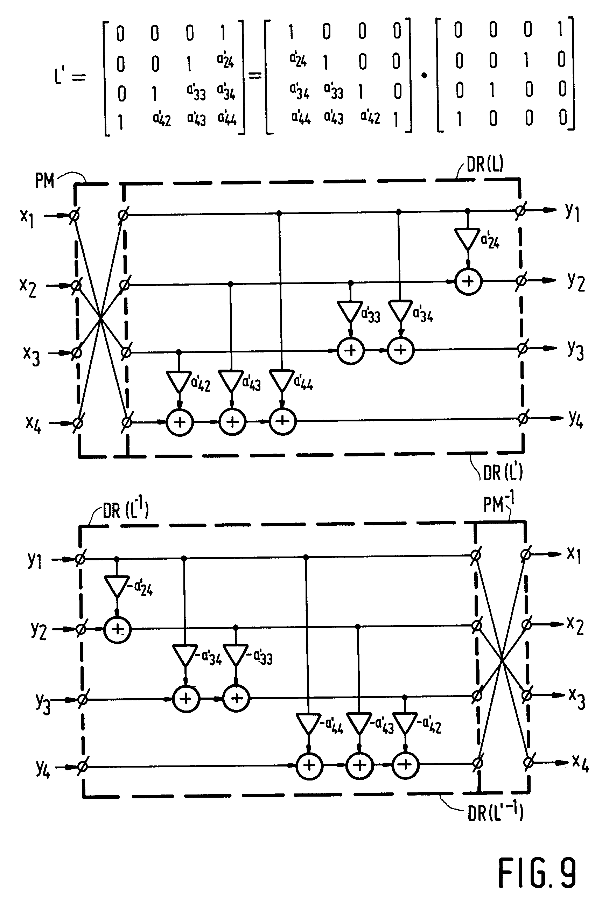

A triangular matrix has diagonal elements which are all equal to one and has non-zero matrix elements on only one side of this diagonal. A triangular matrix may thus occur in four different shapes. These shapes will be denoted by U, L, U', L'. For N = 4 these shapes are shown in Figs. 6, 7, 8 and 9. More particularly, Fig. 6 shows a triangular matrix U whose elements $a'_{rr}$ of the main diagonal (i.e. the diagonal from top left to bottom right) are all one and the other non-zero elements are located above this main diagonal. This triangular matrix U will be referred to as main upper triangular matrix. A second shape of the triangular matrix denoted by L is shown in Fig. 7. It differs from the main upper triangular matrix U in that the non-zero elements are now located below the main diagonal. This triangular matrix L will be referred to as main lower triangular matrix. A third shape is denoted by U' and is shown in Fig. 8. The elements of the auxiliary diagonal (i.e. the diagonal from top right to bottom left) are all equal to one and the other non-zero elements are located above this auxiliary diagonal. This triangular matrix will be referred to as auxiliary upper triangular matrix. The fourth shape which is denoted by L' is shown in Fig. 9. It differs from the auxiliary upper triangular matrix U' in that the non-zero elements are now located below the auxiliary diagonal. This triangular matrix will be referred to as auxiliary lower triangular matrix.

As is shown in Fig. 8, and as can be ascertained in a simple manner, the auxiliary upper triangular matrix U' is equal to the matrix product of a main upper triangular matrix U and a permutation matrix. In a corresponding manner it can be ascertained that, as is shown in Fig. 9, the auxiliary lower triangular matrix L' is equal to the matrix product of a main lower triangular matrix L and a permutation matrix.

In principle, the set of elementary matrices can thus be formed by one permutation matrix, one main upper triangular matrix U and one main lower triangular matrix L. The triangular circuits DR(U) and DR(L) associated with these triangular matrices U and L are also shown in Figs. 6 and 7, respectively. Each of these circuits has N inputs J(1), J(2), J(3), J(4) (in the embodiment shown N is chosen to be 4) and N outputs O(1), O(2), O(3), O(4). Input J(i) receives the input data word $x_i$ of the input data vector and the output data word $y_i$ of the output data vector occurs at output O(i). Input J(i) is connected to output O(i) via a signal channel R(i) and such a signal channel R(i) corresponds to a matrix row r = i. Such a signal channel R(i) comprises a plurality of adder circuits if the matrix row r = i outside the diagonal element $a_{ii}$ - (which is equal to one) comprises further non-zero elements. Such a system of adder circuits receives the input data word $x_i$ from the i-th signal channel R(i) and adds the versions of the other input data words $x_k$ weighted with the non-zero matrix elements $a_{ik}$. In this case k may assume any one of the values 1, 2, ... N, with the exception of the value i. The triangular circuit DR(L) which is shown in Fig. 7 follows from the triangular matrix L of Fig. 7 in the same manner. For the sake of completeness Figs. 8 and 9 show the triangular circuits DR(U') and DR(L') which are associated with the auxiliary upper triangular matrix U' and the auxiliary lower triangular matrix L', respectively. Each triangular circuit comprises a permutation circuit PM which is succeeded, in Fig. 8, by a triangular circuit DR(U) and, in Fig. 9, by a triangular circuit DR(L).

## E(3) The one-dimensional inverse transform.

For realising a one-dimensional forward transform of an input data vector X so as to obtain an output data vector Y, the matrix multiplication

(5)   AX = Y

is performed. By performing a one-dimensional inverse transform, the original input data vector X is regained from the output data vector Y. This inverse transform is defined as follows.

(6)   $X = A^{-1}Y$

In this expression $A^{-1}$ represents the inverse matrix of A. Since the matrix A can be written as the product of a number of permutation and triangular matrices, the inverse matrix $A^{-1}$ can be written as the product of a number of inverse permutation and triangular matrices. Let it particularly be assumed that, for example, $A = P_1 U_1 L_1 P_2 U_2 L_2$, then it holds that:
$A^{-1} = L_2^{-1} U_2^{-1} P_2^{-1} L_1^{-1} U_1^{-1} P_1^{-1}$
In other words, to obtain the inverse matrix $A^{-1}$, each one of the composite matrices must be inverted and the order must be reversed.

For the sake of completeness Figs. 3, 4 and 5 show the inverse matrices at II of the permutation matrices shown at I. Such an inverse permutation matrix comprises the reciprocal elements of the original permutation matrix as non-zero elements; in other words $\tilde{a}_{rk}$ occurs in the inverse permutation matrix as $1/\tilde{a}_{rk}$. The inverse permutation circuits $PM^{-1}$ corresponding to these inverse permutation matrices are shown at IV in Figs. 3, 4 and 5. As may be apparent from these Figures, such an inverse permutation circuit is produced by reversing the signal direction of the corresponding permutation circuit PM (the input becomes the output, and conversely) and by replacing the weighting functions $\tilde{a}_{rk}$ by $1/\tilde{a}_{rk}$.

If it is ensured that $\tilde{a}_{rk}$ and hence $1/\tilde{a}_{rk}$ are chosen to be such that both of them are perfect factors and can thus be represented with a finite word length, the permutation circuit is perfectly inverting, i.e. the inverse permutation circuit yields exactly the same value $x_k$ as the value applied to the permutation circuit. For further clarification we will follow the path of $x_3$ in Fig. 3. This input data word $x_3$ is multiplied by $\tilde{a}_{43}$ and the product $y_4 = \tilde{a}_{43}x_3$ becomes available at output O(4). In the inverse permutation circuit (at IV in Fig. 3) $y_4$ is multiplied by weighting function $1/\tilde{a}_{43}$. The result is that the output data word $y_4/\tilde{a}_{43} = \tilde{a}_{43}x_3/\tilde{a}_{43}$ which is exactly equal to $x_3$ because the quotient $\tilde{a}_{43}/\tilde{a}_{43}$ is exactly equal to 1.

Fig. 6 shows the inverse version $U^{-1}$ next to the main upper triangular matrix U, as well as the corresponding inverse triangular circuit $DR(U^{-1})$. As may be apparent therefrom, this inverse triangular circuit $DR(U^{-1})$ may be derived from the original triangular circuit DR(U) by reversing its signal direction in the signal channels R(i) and inverting the weighting functions, i.e. $a'_{rk}$ becomes $-a'_{rk}$, or, which is the same, the relevant adder circuit is replaced by a subtractor circuit (see III in Fig. 1).

In a corresponding manner, Fig. 7 shows the inverse version $L^{-1}$ next to the main lower triangular matrix L, as well as the corresponding inverse triangular circuit $DR(L^{-1})$. This inverse triangular circuit DR-$(L^{-1})$ can also be derived from the original triangular circuit DR(L) by reversing its signal direction in the signal channels R(i) and inverting the weighting functions ($a'_{rk}$ becomes $-a'_{rk}$).

It will be obvious that these inverse triangular circuits invert perfectly if we follow the path of the input data word $x_3$ in Fig. 6. Added to this input data word in signal channel R(3) is $a'_{34}x_4$ so that it holds that: $y_3 = x_3 + a'_{34}x_4$. In the inverse triangular circuit $DR(U^{-1})$ $a'_{34}y_4 = a'_{34}x_4$ is subtracted from $y_3$ so that $x_3 + a'_{34}x_4 - a'_{34}x_4 = x_3$ remains. This is completely independent of the fact whether a product such as $a'_{34}x_4$ is subjected to some rounding-off operation in order to limit the word length, as long as this operation is identical in both triangular circuits.

For the sake of completeness the path of $x_2$ in Fig. 6 will be followed. The triangular circuit DR(U) yields the output data word $y_2$ for which it holds that:

(7)   $y_2 = x_2 + a'_{23}x_3 + a'_{24}x_4$

In the inverse triangular circuit $DR(U^{-1})$ $a'_{24}y_4$ and $a'_{23}(y_3 - a'_{34}y_4)$ are subtracted from the received data word $y_2$ so that there remains:

$y_2 - a'_{24}y_4 - a'_{23}(y_3 - a'_{34}y_4)$

$$(8)\ldots \qquad = x_2 + a'_{23}x_3 + a'_{24}x_4 - a'_{24}x_4 - a'_{23}(x_3 + a'_{34}x_4 - a'_{34}x_4)$$

$$= x_2$$

It is to be noted that for the sake of completeness Figs. 8 and 9 also show the inverse versions DR-$(U'^{-1})$ and $DR(L'^{-1})$ of the auxiliary upper triangular circuit $DR(U')$ and the auxiliary lower triangular circuit $DR(L')$, respectively.

## E(4) Some examples of application.

In the foregoing sections E(2) and E(3) the elementary transform circuits, to wit the permutation circuit and the triangular circuit are introduced with which each invertible transform matrix can be implemented whose determinant satisfies the previously mentioned conditions. This section will deal with possible transform circuits of some transform matrices in greater detail.

Let it be assumed that the transform matrix F to be implemented has the following shape

$$(9)\ldots \qquad F = \begin{bmatrix} 14 & 1.4 & -15 \\ 14 & 1.7 & -20 \\ 3 & 0.4 & -5 \end{bmatrix}$$

Of this matrix the determinant $| F | = -0.5$ and is thus a perfect factor. This matrix can thus be split up into elementary matrices each also having a determinant which is a perfect factor. A possible split-up is obtained by writing it first as a product of a permutation matrix $P_1$ with determinant $| P_1 | = -0.5$ and an auxiliary matrix G with determinant $| G | = 1$ so that $F = GP_1$. The permutation matrix $P_1$ may be defined, for example, as follows

$$(10)\ldots \qquad P_1 = \begin{bmatrix} 1 & 0 & 0 \\ 0 & 1 & 0 \\ 0 & 0 & -0.5 \end{bmatrix}$$

For the auxiliary matrix G it then holds:

$$(11)\ldots \qquad G = \begin{bmatrix} 14 & 1.4 & 30 \\ 14 & 1.7 & 40 \\ 3 & 0.4 & 10 \end{bmatrix}$$

In its turn, this auxiliary matrix G may be split up into, for example, the following four matrices each having a determinant which is equal to one,

$$U = \begin{bmatrix} 1 & 2 & 3 \\ 0 & 1 & 4 \\ 0 & 0 & 1 \end{bmatrix}$$

(12)...

$$L = \begin{bmatrix} 1 & 0 & 0 \\ 2 & 1 & 0 \\ 3 & 4 & 1 \end{bmatrix} \qquad P_2 = \begin{bmatrix} 1 & 0 & 0 \\ 0 & 0.1 & 0 \\ 0 & 0 & 10 \end{bmatrix}$$

such that $F = ULP_2P_1$.

The diagonal matrix $P_2$ obtained with this decomposition has a matrix element (*viz.* 0.1) which is not a perfect factor. This would mean that the matrix F could not be the basis for a perfectly inverting circuit. However, this problem may be solved as follows. Since the determinant of $P_2$ is equal to 1, $P_2$ can be split up in itself, for example, into the matrices

$$U_{2.1} = \begin{bmatrix} 1 & 0 & 0 \\ 0 & 1 & -0.1 \\ 0 & 0 & 1 \end{bmatrix} \qquad L_{2.1} = \begin{bmatrix} 1 & 0 & 0 \\ 0 & 1 & 0 \\ 0 & 9 & 1 \end{bmatrix}$$

(13)...

$$U_{2.2} = \begin{bmatrix} 1 & 0 & 0 \\ 0 & 1 & 1 \\ 0 & 0 & 1 \end{bmatrix} \qquad L_{2.2} = \begin{bmatrix} 1 & 0 & 0 \\ 0 & 1 & 0 \\ 0 & -0.9 & 1 \end{bmatrix}$$

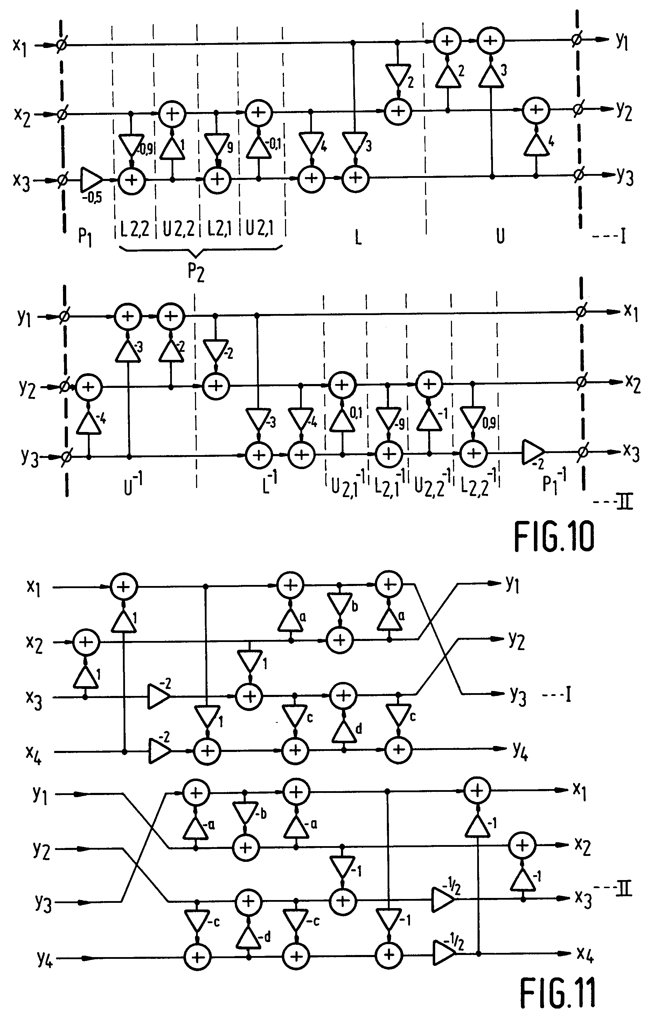

so that it holds that: $P_2 = U_{2.1} \cdot L_{2.1} \cdot U_{2.2} \cdot L_{2.2}$ and $F = ULU_{2.1}L_{2.1}U_{2.2}L_{2.2}P_1$, so that F can be implemented in the way as is shown at I in Fig. 10. For the sake of completeness the implementation of the inverse matrix $F^{-1}$ is shown at II in Fig. 10.

Another transform matrix, an embodiment of which will herein be described, is the Discrete Cosine Transform matrix which is very popular in picture transform coding. As is generally known, the matrix elements $a_{rk}$ of an N*N DCT matrix are defined as follows.

Although N = 8 is generally chosen for picture transform coding, an example for the

(14)...

$$a_{rk} = \begin{cases} \dfrac{1}{\sqrt{N}} & \textit{for } r = 1 \\[2ex] \sqrt{\dfrac{2}{N}} \, \cos\dfrac{(2k+1)(r-1)\pi}{2N} & \textit{for } 2 \leq r \leq N \end{cases}$$

case where N = 4 will be given here so as not to complicate and hence obscure the matter needlessly. Then it holds that:

8

$$(15)\ldots \qquad a_{rk} = \begin{cases} \dfrac{1}{2} & for\ r = 1 \\[2mm] \dfrac{1}{2}\sqrt{2}\ \cos\dfrac{\pi}{8}(2k+1)(r-1) & for\ 2 \le r \le 4 \end{cases}$$

This DCT matrix, which will be denoted by DCT(4), then has the following shape, the matrix elements being limited to three decimal places.

$$(16)\ldots \qquad DCT(4) \approx \begin{bmatrix} 0.500 & 0.500 & 0.500 & 0.500 \\ 0.653 & 0.271 & -0.271 & -0.653 \\ 0.500 & -0.500 & -0.500 & 0.500 \\ 0.271 & -0.653 & 0.653 & -0.271 \end{bmatrix}$$

In view of the number of adder circuits and weighting networks required for implementation of this DCT(4) matrix, it is found to be favourable in practice to realise a $\sqrt{2}$ scaled version of this DCT(4) matrix. Such a scaling can be considered as a constant amplification for all coefficients and thus does not influence the mutual ratio of these coefficients and hence the desired information. This scaled version will be represented by DCT(4)', its relation with DCT(4) is as follows:

DCT(4)' = $\sqrt{2}$ DCT(4)

This matrix DCT(4)' then has the following shape

$$(17)\ldots \qquad DCT(4)' = \begin{bmatrix} 0.707 & 0.707 & 0.707 & 0.707 \\ 0.924 & 0.383 & -0.383 & -0.924 \\ 0.707 & -0.707 & -0.707 & 0.707 \\ 0.383 & -0.924 & 0.924 & -0.383 \end{bmatrix}$$

The determinant of DCT(4)' is equal to $4(= 2^2)$ and this matrix can thus be decomposed, for example, it can be written as the following product of matrices

$$DCT(4)' = \begin{bmatrix} 0 & 1 & 0 & 0 \\ 0 & 0 & 1 & 0 \\ 1 & 0 & 0 & 0 \\ 0 & 0 & 0 & 1 \end{bmatrix} \cdot \begin{bmatrix} 1 & a & 0 & 0 \\ 0 & 1 & 0 & 0 \\ 0 & 0 & 1 & 0 \\ 0 & 0 & 0 & 1 \end{bmatrix} \cdot \begin{bmatrix} 1 & 0 & 0 & 0 \\ b & 1 & 0 & 0 \\ 0 & 0 & 1 & 0 \\ 0 & 0 & 0 & 1 \end{bmatrix} \cdot \begin{bmatrix} 1 & a & 0 & 0 \\ 0 & 1 & 0 & 0 \\ 0 & 0 & 1 & 0 \\ 0 & 0 & 0 & 1 \end{bmatrix} \cdot \begin{bmatrix} 1 & 0 & 0 & 0 \\ 0 & 1 & 0 & 0 \\ 0 & 0 & 1 & 0 \\ 0 & 0 & c & 1 \end{bmatrix} \cdot$$

$$(18)\ldots$$

$$\cdot \begin{bmatrix} 1 & 0 & 0 & 0 \\ 0 & 1 & 0 & 0 \\ 0 & 0 & 1 & d \\ 0 & 0 & 0 & 1 \end{bmatrix} \cdot \begin{bmatrix} 1 & 0 & 0 & 0 \\ 0 & 1 & 0 & 0 \\ 0 & 0 & 1 & 0 \\ 0 & 0 & c & 1 \end{bmatrix} \cdot \begin{bmatrix} 1 & 0 & 0 & 0 \\ 0 & 1 & 0 & 0 \\ 0 & 1 & 1 & 0 \\ 1 & 0 & 0 & 1 \end{bmatrix} \cdot \begin{bmatrix} 1 & 0 & 0 & 0 \\ 0 & 1 & 0 & 0 \\ 0 & 0 & -2 & 0 \\ 0 & 0 & 0 & -2 \end{bmatrix} \cdot \begin{bmatrix} 1 & 0 & 0 & 1 \\ 0 & 1 & 1 & 0 \\ 0 & 0 & 1 & 0 \\ 0 & 0 & 0 & 1 \end{bmatrix}$$

$a = 1-\sqrt{2} \approx -0.4142$

$b = \frac{1}{2}\sqrt{2} \approx +0.7071$

in which

$$c = \tan\frac{\pi}{8} - \frac{1}{\cos\frac{\pi}{8}} \approx -0.6682$$

$d = \cos\frac{\pi}{8} \approx 0.9239$

The implementation of this transform matrix DCT(4)' is shown at I in Fig. 11 and that of the inverse matrix DCT(4)'$^{-1}$ is shown at II in Fig. 11.

It is to be noted again that this split-up is not unique and that methods of realising such a split-up are generally known from the matrix theory, see, for example Reference 3, so that this aspect will not be further dealt with.

## E(4) Subband coding.

As is generally known, subband coding is a technique in which the frequency band of a signal is split up into a number of subbands (for example, N) and the sample frequency of the signal in such a subband is reduced by a factor of N so as to generate N subband signals. Each subband signal is subsequently quantized in a manner which is optimal for the relevant subband.

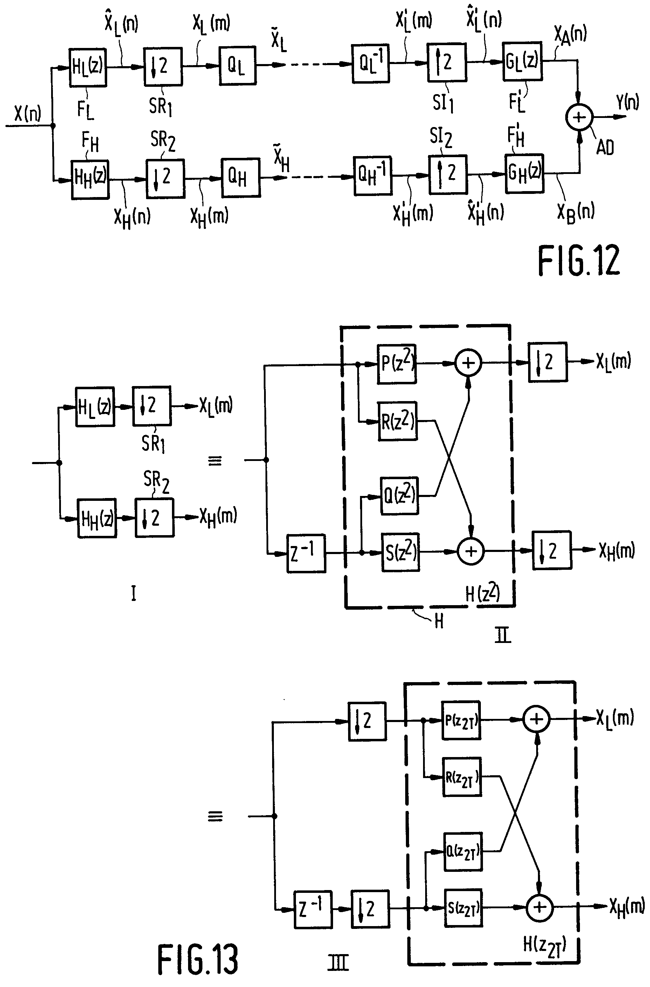

This general principle of subband coding is shown in Fig. 12 for N = 2. The time-discrete signal x(n) is subjected in filters $F_L$ and $F_H$ to a low-pass and a high-pass filter operation $H_L(z)$ and $H_H(z)$, respectively. The sample frequencies of the signals $\widehat{x}_L(n)$ and $\widehat{x}_H(n)$ thus obtained are subsequently reduced by a factor of 2 in sample rate reducing circuits SR1 and SR2 so that the subband signals $x_L(m)$ and $x_H(m)$ are obtained. After subjecting the subband signals to quantizing operations $Q_L$ and $Q_H$ respectively, the quantized subband signals $\widetilde{x}_L$ and $\widetilde{x}_H$ are transmitted to some receiver station. In this station the quantized subband signals are subjected to inverse quantizing operations $Q_L^{-1}$ and $Q_H^{-1}$ so that the subband signals $x_L'(m)$ and $x_H'(m)$ are obtained. In sample rate increasing circuits SI1 and SI2 the sample frequencies of these signals are increased by a factor of two. The signals $\widehat{x}_L'(n)$ and $\widehat{x}_H'(n)$ thus obtained are subsequently subjected in filters $F_L'$ and $F_H'$ to a low-pass and a high-pass filtering operation $G_L(z)$ and $G_H(z)$, respectively. The signals $x_A(n)$ and $x_B(n)$ thus obtained are added together in an adder circuit AD so that the output signal y(n) is obtained which largely corresponds to x(n). The multirate filter network comprising the filters $F_L$ and $F_H$ as well as the two sample rate reducing circuits SR1 and SR2 is referred to as band-splitting network. Analogously, the multirate filter network comprising the filters $F_L'$ and $F_H'$, as well as the two sample rate increasing circuits SI1 and SI2 is referred to as reconstruction network.

It will be evident that, except for some gain factor, the aim is to bring the output signal y(n) in conformity with the input signal x(n) as much as possible. Another aim is not to introduce any further (rounding or quantizing) errors if y(n) must again be subjected to a subband coding for some reason. The latter object can be realised by at least ensuring that the reconstruction network reconstructs perfectly, *i.e.* the output signal of the reconstruction network (except for a possible gain factor) is exactly equal to the input signal of the band-splitting network. This can be achieved by realising implementations for these networks which emanate from the technique described hereinbefore for transform networks. However, this requires the operation of the band-splitting network to be written as a matrix. To this end, the starting point is the following general mathematical description of the filter functions $H_L(z)$ and $H_H(z)$

$H_L(z) = a_{L0} + a_{L1}z^{-1} + a_{L2}z^{-2} + a_{L3}z^{-3} + ...$
(19)    $H_H(z) = a_{H0} + a_{H1}z^{-1} + a_{H2}z^{-2} + a_{H3}z^{-3} + ...$

Such a system of filter functions can be written as a matrix as follows.

$$(20)... \qquad \begin{bmatrix} H_L(z) \\ H_H(z) \end{bmatrix} = \begin{bmatrix} P(z^2) & Q(z^2) \\ R(z^2) & S(z^2) \end{bmatrix} \begin{bmatrix} 1 \\ z^{-1} \end{bmatrix}$$

In this expression the matrix elements $P(z^2)$ $Q(s^2)$ $R(z^2)$ and $S(z^2)$ represent polynomials of the variable $z^2$. Thus, it holds, for example, that

$$P(z^2) = a_{L0} + a_{L2}z^{-2} + a_{L4}z^{-4} + ...$$
$$Q(z^2) = a_{L1} + a_{L3}z^{-2} + a_{L5}z^{-4} + ...$$
(21)
$$R(z^2) = a_{H0} + a_{H2}z^{-2} + a_{H4}z^{-4} + ...$$
$$S(z^2) = a_{H1} + a_{H3}z^{-2} + a_{H5}z^{-4} + ...$$

As is generally known from the theory of digital signal processing, the quantity $z^{-1}$ represents a delay of one sampling period T of the signal applied to the filter. The quantity $z^{-2}$ then represents a delay of two sampling periods T. In the case considered, in which N = 2, the period 2T is equal to the period with which the samples occur at the output of the sample rate reducing circuits SR1 and SR2 (see Fig. 12). By introducing a variable $z_{2T}$ in such a way that $z^{-1}_{2T}$ is a delay of two input sampling periods 2T, expression (21) can be rewritten as:

$$P(z_{2T}) = a_{L0} + a_{L2}z^{-1}_{2T} + a_{L4}z^{-2}_{2T} + ...$$
$$Q(z_{2T}) = a_{L1} + a_{L3}z^{-1}_{2T} + a_{L5}z^{-2}_{2T} + ...$$

(22)...

$$R(z_{2T}) = a_{H0} + a_{H2}z^{-1}_{2T} + a_{H4}z^{-2}_{2T} + ...$$
$$S(z_{2T}) = a_{H1} + a_{H3}z^{-1}_{2T} + a_{H5}z^{-2}_{2T} + ...$$

The physical significance of the foregoing is illustrated in Fig. 13. More particularly, the original band-splitting network is shown at I and the equivalent band-splitting network whose implementation is based on expression (20) is shown at II. The filter network H which is present therein has a transfer function which is dependent on the variable $z^2$. Since this filter network H is followed by sample rate reducing circuits SR1 and SR2 each having a reduction factor of two, we can speak of a "noble identity" (see Reference 5) so that the filter network H and the two sample rate reducing circuits SR1 and SR2 may be interchanged. This leads to the equivalent band-splitting network shown at III in Fig. 13.

If, in a corresponding manner, the starting point is the following general description of the filter functions $G_L(z)$ and $G_H(z)$

$$G_L(z) = g_{L0} + g_{L1}z^{-1} + g_{L2}z^{-2} + g_{L3}z^{-3} + ...$$
(23)    $$G_H(z) = g_{H0} + g_{H1}z^{-1} + g_{H2}z^{-2} + g_{H3}z^{-3} + ...$$

then this system of filter functions can also be written as a matrix

$$(24)... \qquad \begin{bmatrix} G_L(z) \\ G_H(z) \end{bmatrix} = [z^{-1}\ 1] \begin{bmatrix} T(z^2) & U(z^2) \\ V(z^2) & W(z^2) \end{bmatrix}$$

Here again the matrix elements $T(z^2)$, $U(z^2)$, $V(z^2)$ and $W(z^2)$ represent polynomials of the variable $z^2$. It then holds, for example, that:

$$T(z^2) = g_{L1} + g_{L3}z^{-2} + g_{L5}z^{-4} + ...$$
$$V(z^2) = g_{L0} + g_{L2}z^{-2} + g_{L4}z^{-4} + ...$$
$$U(z^2) = g_{H1} + g_{H3}z^{-2} + g_{H5}z^{-4} + ...$$
(25)    $$W(z^2) = g_{H0} + g_{H2}z^{-2} + g_{H4}z^{-4} + ...$$

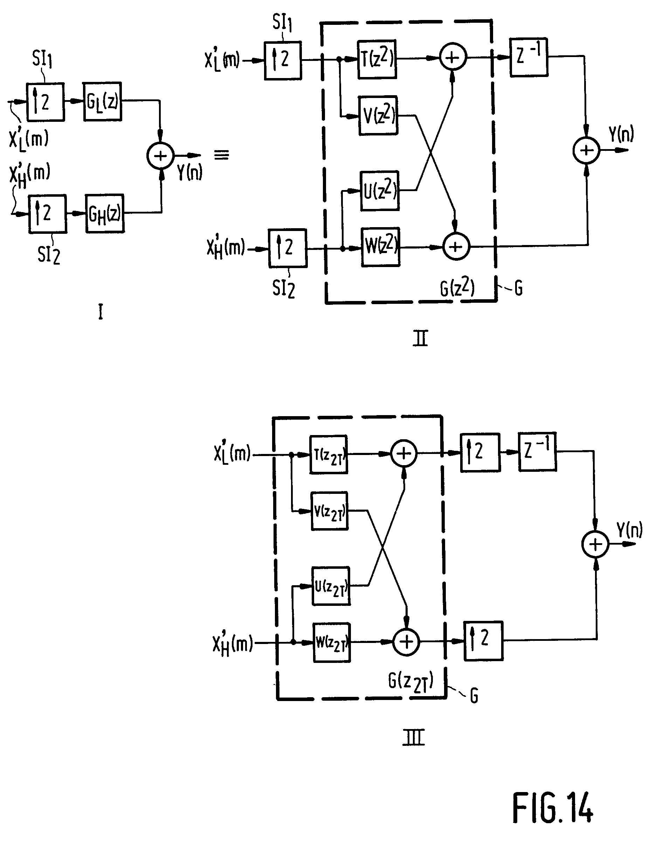

This means that the original reconstruction network, which is shown at I in Fig. 14 for the sake of completeness, is equivalent to the reconstruction network shown at II in Fig. 14. Since the filter network G and the sample rate increasing circuits SI1 and SI2 also form a "noble identity" in this case, they may be interchanged so that the equivalent reconstruction network is obtained which is shown at III in Fig. 14 and in which the original variable $z^2$ has again been replaced by $z_{2T}$.

For a satisfactory operation of this subband coder the reconstruction network G should be perfectly inverting. This can be realised in the manner as already described hereinbefore for transform matrices. More particularly, in the relevant case a matrix $D(z_{2T})$ is defined as follows by means of the polynomials in the variable $z_{2T}$ given in expression (22)

$$(26)\dots \qquad D(z_{2T}) = \begin{bmatrix} P(z_{2T}) & Q(z_{2T}) \\ R(z_{2T}) & S(z_{2T}) \end{bmatrix}$$

This matrix can be decomposed if its determinant is equal to

$$c(z_{2T}^{-1})^q$$

in which q is a positive integer including zero and c is a perfect factor. The following filter functions will be taken as examples:

$$H_L(z) = 0.76 + 0.856 \, z^{-1} + 0.16 \, z^{-2} - 0.304 \, z^{-3} - 0.0192 \, z^{-4} + 0.02048 \, z^{-5}$$
$$H_H(z) = -0.6 + 0.64 \, z^{-1} - 0.2 \, z^{-2} - 0.12 \, z^{-3} - 0.048 \, z^{-4} + 0.0512 \, z^{-5}$$

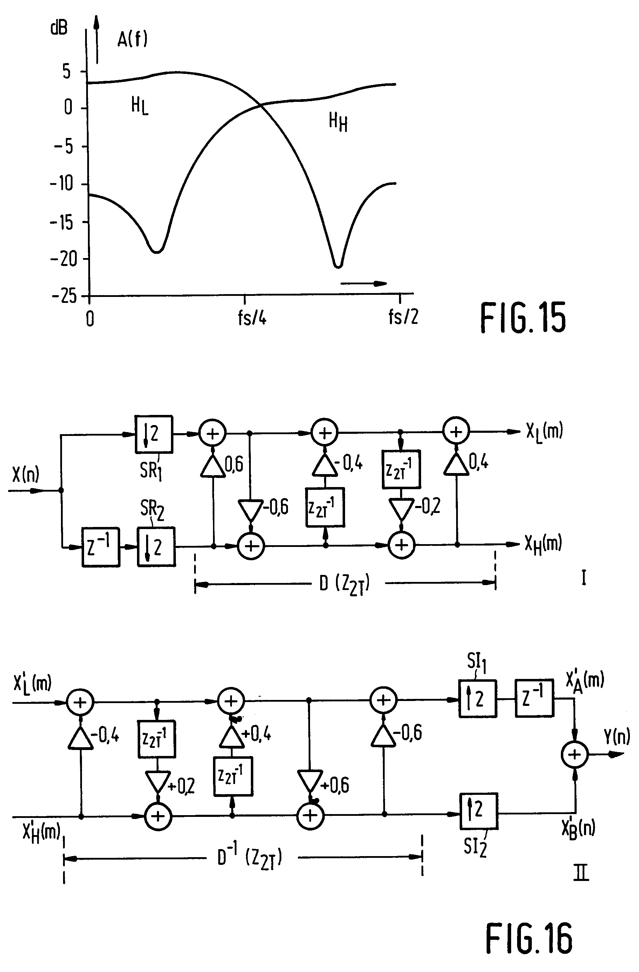

whose amplitude frequency characteristics are shown in Fig. 15. The following matrix elements can be derived from these filter functions

$$(27)\dots \qquad \begin{aligned} P(z_{2T}) &= 0.76 + 0.16 \, z_{2T}^{-1} - 0.0192 \, z_{2T}^{-2} \\ Q(z_{2T}) &= 0.856 - 0.304 \, z_{2T}^{-1} + 0.02048 \, z_{2T}^{-2} \\ R(z_{2T}) &= -0.6 - 0.2 \, z_{2T}^{-1} - 0.048 \, z_{2T}^{-2} \\ S(z_{2T}) &= 0.64 - 0.12 \, z_{2T}^{-1} + 0.0512 \, z_{2T}^{-2} \end{aligned}$$

The matrix $D(z_{2T})$ to be composed therewith can then be decomposed, for example, in the following way

$$(28)\dots \quad D(z_{2T}) = \begin{bmatrix} 1 & 0.4 \\ 0 & 1 \end{bmatrix} \begin{bmatrix} 1 & 0 \\ -0.2z_{2T}^{-1} & 1 \end{bmatrix} \begin{bmatrix} 1 & -0.4z_{2T}^{-1} \\ 0 & 1 \end{bmatrix} \begin{bmatrix} 1 & 0 \\ -0.6 & 1 \end{bmatrix} \begin{bmatrix} 1 & 0.6 \\ 0 & 1 \end{bmatrix}$$

With the above choice of the filter functions, the band-splitting network ($F_L$, $F_H$, SR1, SR2) of Fig. 12 can be implemented, for example, in the manner as shown at I in Fig. 16 and the associated reconstruction filter (SI1, SI2, $F_L'$, $F_H'$) can be implemented in the manner as shown at II in Fig. 16.

It is to be noted that in the case of subband coding there are matrix elements which are no longer a constant, as is the case in, for example picture transform coding (for example, in the DCT), but are functions of the variable $z$.

## Claims

1. A device for subjecting a cluster of N time-discrete input signals to a one-dimensional forward transform on which an invertible N*N transform matrix is based, characterized in that the device comprises a cascade arrangement of a plurality of permutation circuits and a plurality of triangular circuits, a permutation matrix with matrix elements $\tilde{a}_{rk}$ being associated with each permutation circuit

EP 0 544 356 A2

and a triangular matrix with matrix elements $a'_{rk}$ being associated with each triangular circuit, the mutual sequence of said circuits being determined by the transform matrix and each circuit having N inputs and N outputs for receiving auxiliary input signals and supplying auxiliary output signals, respectively; the permutation circuit being adapted to supply auxiliary output signals at its different outputs, the auxiliary output signal at the output having ordinal number r being a weighted version of the auxiliary input signal at a predetermined input having ordinal number k whereby the weighting function is described by the matrix element $\tilde{a}_{rk}$, the triangular circuit being adapted to supply an auxiliary output signal at each of its outputs r, which signal is equal to the auxiliary input signal at its input k, augmented with weighted versions of auxiliary input signals at other inputs $q \neq k$, the weighting function to which the auxiliary input signal at input q is subjected for determining its contribution to the auxiliary output signal at output r being exclusively described by the matrix element $a'_{rq}$.

2. A device for subjecting a cluster of N time-discrete input signals to a one-dimensional transform which is inverse to the one-dimensional forward transform as claimed in Claim 1, characterized in that said device has the same structure as the device for performing the one-dimensional forward transform as claimed in Claim 1, whereby with respect to the last-mentioned device the inputs and the outputs are interchanged, the polarity of the weighting functions of the triangular circuits is inverted and the weighting functions of the permutation circuits are reciprocal.

13

FIG.1

$$I \cdots \begin{bmatrix} a_{11} & a_{12} & a_{13} & a_{14} & a_{15} & \cdots & a_{1N} \\ a_{21} & a_{22} & a_{23} & a_{24} & a_{25} & \cdots & a_{2N} \\ a_{31} & a_{32} & a_{33} & a_{34} & a_{35} & \cdots & a_{3N} \\ a_{41} & a_{42} & a_{43} & a_{44} & a_{45} & \cdots & a_{4N} \\ & \vdots & & & & & \\ a_{N1} & a_{N2} & a_{N3} & a_{N4} & a_{N5} & \cdots & a_{NN} \end{bmatrix} \cdot \begin{bmatrix} x_1 \\ x_2 \\ x_3 \\ x_4 \\ \vdots \\ x_N \end{bmatrix} = \begin{bmatrix} y_1 \\ y_2 \\ y_3 \\ y_4 \\ \vdots \\ y_N \end{bmatrix}$$

$$A \qquad\qquad \cdot \quad X \quad = \quad Y$$

$$
II \cdots
\begin{aligned}
y_1 &= a_{11} x_1 + a_{12} x_2 + a_{13} x_3 + \cdots \cdots a_{1N} x_N \\
y_2 &= a_{21} x_1 + a_{22} x_2 + a_{23} x_3 + \cdots \cdots a_{2N} x_N \\
y_3 &= a_{31} x_1 + a_{32} x_2 + a_{33} x_3 + \cdots \cdots a_{3N} x_N \\
&\ \ \vdots \\
y_N &= a_{N1} x_1 + a_{N2} x_2 + a_{N3} x_3 + \cdots \cdots a_{NN} x_N
\end{aligned}
$$

FIG.2

$$I \cdots \begin{bmatrix} 0 & \bar{a}_{12} & 0 & 0 \\ 0 & 0 & 0 & \bar{a}_{24} \\ \bar{a}_{31} & 0 & 0 & 0 \\ 0 & 0 & \bar{a}_{43} & 0 \end{bmatrix} \Rightarrow \begin{bmatrix} 0 & 0 & 1/\bar{a}_{31} & 0 \\ 1/\bar{a}_{12} & 0 & 0 & 0 \\ 0 & 0 & 0 & 1/\bar{a}_{43} \\ 0 & 1/\bar{a}_{24} & 0 & 0 \end{bmatrix} \cdots II$$

FIG:3

$$I \cdots \begin{bmatrix} \bar{a}_{11} & 0 & 0 & 0 \\ 0 & 0 & \bar{a}_{23} & 0 \\ 0 & 0 & 0 & \bar{a}_{34} \\ 0 & \bar{a}_{42} & 0 & 0 \end{bmatrix} \Rightarrow \begin{bmatrix} 1/\bar{a}_{11} & 0 & 0 & 0 \\ 0 & 0 & 0 & 1/\bar{a}_{42} \\ 0 & 1/\bar{a}_{23} & 0 & 0 \\ 0 & 0 & 1/\bar{a}_{34} & 0 \end{bmatrix} \cdots II$$

FIG.4

15

$$I \cdots \begin{bmatrix} \bar{a}_{11} & 0 & 0 & 0 \\ 0 & \bar{a}_{22} & 0 & 0 \\ 0 & 0 & \bar{a}_{33} & 0 \\ 0 & 0 & 0 & \bar{a}_{44} \end{bmatrix} \Longrightarrow \begin{bmatrix} 1/\bar{a}_{11} & 0 & 0 & 0 \\ 0 & 1/\bar{a}_{22} & 0 & 0 \\ 0 & 0 & 1/\bar{a}_{33} & 0 \\ 0 & 0 & 0 & 1/\bar{a}_{44} \end{bmatrix} \cdots II$$

FIG.5

$$U = \begin{bmatrix} 1 & a'_{12} & a'_{13} & a'_{14} \\ 0 & 1 & a'_{23} & a'_{24} \\ 0 & 0 & 1 & a'_{34} \\ 0 & 0 & 0 & 1 \end{bmatrix} \qquad U^{-1} = \begin{bmatrix} 1 & -a'_{12} & a'_{12}a'_{23}-a'_{13} & a'_{12}a'_{24}+a'_{13}a'_{34}-a'_{14}-a'_{12}a'_{23}a'_{34} \\ 0 & 1 & -a'_{23} & a'_{23}a'_{34}-a'_{24} \\ 0 & 0 & 1 & -a'_{34} \\ 0 & 0 & 0 & 1 \end{bmatrix}$$

FIG.6

$$L = \begin{bmatrix} 1 & 0 & 0 & 0 \\ a'_{21} & 1 & 0 & 0 \\ a'_{31} & a'_{32} & 1 & 0 \\ a'_{41} & a'_{42} & a'_{43} & 1 \end{bmatrix} \qquad L^{-1} = \begin{bmatrix} 1 & 0 & 0 & 0 \\ -a'_{21} & 1 & 0 & 0 \\ a'_{21}a'_{32} - a'_{31} & -a'_{32} & 1 & 0 \\ a'_{21}a'_{42} + a'_{31}a'_{43} - a'_{41} - a'_{21}a'_{32}a'_{43} & a'_{32}a'_{43} - a'_{42} & -a'_{43} & 1 \end{bmatrix}$$

FIG.7

$$U' = \begin{bmatrix} a'_{11} & a'_{12} & a'_{13} & 1 \\ a'_{21} & a'_{22} & 1 & 0 \\ a'_{31} & 1 & 0 & 0 \\ 1 & 0 & 0 & 0 \end{bmatrix} = \begin{bmatrix} 1 & a'_{13} & a'_{12} & a'_{11} \\ 0 & 1 & a'_{22} & a'_{21} \\ 0 & 0 & 1 & a'_{31} \\ 0 & 0 & 0 & 1 \end{bmatrix} \cdot \begin{bmatrix} 0 & 0 & 0 & 1 \\ 0 & 0 & 1 & 0 \\ 0 & 1 & 0 & 0 \\ 1 & 0 & 0 & 0 \end{bmatrix}$$

FIG.8

$$L' = \begin{bmatrix} 0 & 0 & 0 & 1 \\ 0 & 0 & 1 & a'_{24} \\ 0 & 1 & a'_{33} & a'_{34} \\ 1 & a'_{42} & a'_{43} & a'_{44} \end{bmatrix} = \begin{bmatrix} 1 & 0 & 0 & 0 \\ a'_{24} & 1 & 0 & 0 \\ a'_{34} & a'_{33} & 1 & 0 \\ a'_{44} & a'_{43} & a'_{42} & 1 \end{bmatrix} \cdot \begin{bmatrix} 0 & 0 & 0 & 1 \\ 0 & 0 & 1 & 0 \\ 0 & 1 & 0 & 0 \\ 1 & 0 & 0 & 0 \end{bmatrix}$$

FIG.9

EP 0 544 356 A2

FIG.10

FIG.11

21

FIG.12

FIG.13

FIG.14

FIG.15

I

II

FIG.16